# EUROPEAN PATENT SPECIFICATION

(11) **EP 0 607 651 B1**
(45) Date of publication and mention of the grant of the patent: **07.01.1998**
(21) Application number: 93307463.5
(22) Date of filing: 21.09.1993
(51) Int. Cl.: C23C 16/40, C23C 16/44, B01J 19/00, C10G 9/20

(54) **Prevention of fuel thermal degradation deposits**
Verhütung von Ablagerungen thermischer Zersetzungsprodukte von Brennstoff
Prévention des dépôts de carburant formés par décomposition thermique

(30) Priority: 15.01.1993 US 6104
(43) Date of publication of application: 27.07.1994
(73) Proprietor: GENERAL ELECTRIC COMPANY, Schenectady, NY 12345 (US)
(72) Inventor: Coffinberry, George Albert, West Chester, Ohio 45069 (US); Ackerman, John Frederick, Cheyenne, Wyoming 82001 (US)
(74) Representative: Goode, Ian Roy

(56) References cited:
- EP-A- 0 414 270
- EP-A- 0 479 375
- EP-A- 0 589 679
- EP-A- 0 608 081
- CA-A- 2 062 024
- FR-A- 2 144 823
- US-A- 3 475 192
- US-A- 4 297 150

## Description

### BACKGROUND OF THE INVENTION

The present invention relates generally to deposits formed on surfaces in contact with hydrocarbon fluids, and more particularly, to a method of preventing or reducing the deposit of hydrocarbon fluid thermal degradation products on surfaces in contact therewith and to a metal article having a coated surface which inhibits the formation of gum and/or coke formed by thermal degradation of the fluid, without resorting to modification of the fluid, without adoption of special procedures and without installation of special equipment for their use.

As used herein, hydrocarbon fluid is defined as one or more hydrocarbon liquids, hydrocarbon gases or mixtures thereof. As used herein, "hydrocarbon fluid degradation products" or "thermal degradation products" includes products which form from the hydrocarbons, for example, certain polymers resulting from thermal transformation of paraffins to cycloparaffins, aromatics and polycyclic molecules in the hydrocarbon, as well as products which result from actual decomposition of the fuel, e.g., carbon.

Because high temperature is usually associated with undesirable levels of hydrocarbon fluid deposit formation, the technical subject herein is customarily referred to as thermal instability, or in the case of fuels, as fuel instability. Flowing hydrocarbon fluids including lubricating oils, hydraulic oils and combustible fuels form gum and coke deposits on the surface of containment walls and other parts which they contact, when the fluid and/or surface are heated.

The mechanisms for formation of deposits from thermal instability have been studied and documented. In the case of fuels, it is generally accepted that there are two distinct mechanisms occurring at two levels of temperature. In the first mechanism, referred to as the coking process, as temperature increases from room temperature, starting at about 300°F (about 149°C) there is generally a consistent increase in the rate of formation of coke deposits up to about 1200°F (about 649°C) where high levels of hydrocarbon lead to coke formation and eventually limit the usefulness of the fuel. A second lower temperature mechanism starting at about room temperature, generally peaks at about 700°F (about 370°C) and involves the formation of gum deposits. This second mechanism is generally better understood than the coking process. It involves oxidation reactions which lead to polymerization which includes the formation of gums. Both coke and gum formation and deposits can occur simultaneously in the mid-temperature region.

Coke formation in hydrocarbons is discussed in U.S. Patent No. 2,698,512, and heat stability of jet fuel and the consequences of thermal degradation of the fuel are discussed in U.S. Patent No. 2,959,915 . These patents suggest specific formulations which place limitations on the fuel chemistry and impurities associated with hydrocarbon fuels so that the fuels will be usable at high temperatures without the typical formation of gums and coke.

Gum and coke formation are discussed in U.S. Patent No. 3,173,247. It is indicated therein that at very high flight speeds, heat must be transferred, particularly from the engine, to some part of the flight vehicle or to its load, and although the fuel which is stored on the vehicle, could serve to receive this heat, in practice, such procedure is unfeasible because jet fuels are not stable to the high temperatures which are developed at multi-Mach speeds, instead, they decompose to produce intolerable amounts of insoluble gum or other deposits, for example coke. As with the previously referenced patents, the solution to the problem has been directed toward limitations on fuel chemistry and impurities associated with the fuel.

The chemistry of the hydrocarbon fluid mixture and the chemistry of the containment vessel can have a major influence on deposit mechanisms and deposit rates at temperatures where it is most desirable to use the fluid. Hydrocarbon fluids contain impurities, of which sulfur and dissolved oxygen from air, are major constituents. Gums are essentially vinyl polymers formed by reactions between oxygen and olefins in hydrocarbon fluids. Coke can also be in the form of carbon polymers and can have crystalline structures, and deposits formed from decomposition products of hydrocarbon fluids, are often observed to be a mixture of gum, coke, hydrocarbons and other impurities. Gums adhere to surfaces much in the same way as glues, and accordingly, they tend to entrap other solid particles such as coke, solid hydrocarbon impurities (or products), and the like and thereby form deposits on surfaces which they contact. In the lower temperature region where gum formation occurs, oxygen from air dissolved in the liquid is the major adverse ingredient. Boiling amplifies this adversity because of the oxygen concentration effect adjacent to hot walls. If oxygen or air is absent, gum formation is not likely to occur.

In much of the prior art, the problems associated with gum and coke thermal deposits have predominately dealt with bulk fluid chemistry and reactions which can take place within the fluid. These investigations have involved a wide range of hydrocarbon compositions and the presence of numerous impurities such as sulfur compounds, nitrogen compounds, oxygen and trace metals. It has been observed that deposits attached to containment walls often contain very large quantities of sulfur and nitrogen compounds or intermediates thereof in addition to gums and cokes. Little attention has, however, been given in the prior art to the role of the chemistry and reactions which take place in the vicinity of the containment walls and the fluid.

In U.S. Patent No. 3,157,990, certain phosphate additives are added to the monopropellant wherein the phosphates decompose in the reaction chamber and form a coating, probably a phosphate coating, on the internal generator surfaces, and it is suggested that this coating effectively inhibits carbon decomposition and scaling. In U.S. Patent No. 3,236,046, the interior surfaces of stainless steel gas generators are passivated with sulfurous materials to overcome deposition of coke on the surfaces of the gas generator, and passivation is defined as a pretreatment which substantially reduces initial catalytic coke formation.

In U.S. Patent No. 4,078,604, heat exchangers are characterized by thin-walled corrosion resistant layers of electrodeposited gold or similar corrosion-resistant metals on the walls of the cooling channels within the inner wall, and the cooling channels are covered with the electro-deposited layer of gold in order to make the surfaces corrosion resistant to such storable liquid fuels as red fuming nitric acid. In this prior art case, the wall is protected from corrosion by the propellent, but the intent is not to prevent deposit formations.

CA 2062024 discloses generally the possibilities of providing a liner on substrate surfaces, the liner being in the form of catalytically active or catalytically inactive diffusion barrier layer, for example metal oxide filings. However problems have been found in applying said layers successfully in practise.

Protective metal oxide films on metal or alloy substrate surfaces susceptible to coking, corrosion or catalytic activity are referred to in U.S. Patent No. 4,297,150, where it is first necessary to pre-oxidize a substrate surface and then to deposit on the pre-oxidized surface a metal oxide of calcium, magnesium, aluminum, gallium, titanium, zirconium, hafnium, tantalum, niobium or chromium by vapor phase decomposition of a volatile compound of the metal, wherein nitrogen, helium, argon, carbon dioxide, air or steam may be used as carrier gases for the metal compound, the volatile compound having at least one metal-oxygen bond.

In United States Patent No. 4,343,658, reference is made to the protection of metal substrate surfaces against carbon accumulation when exposed to an environment wherein carbon-containing gases are decomposed, by the use of tantalum and/or tungsten entities deposited and/or diffused into the surface of the substrate. According to U.S. Patent No. 4,343,658, filamentous carbon grows on surfaces at a reduced rate (by a factor of at least four) when the tantalum and/or tungsten entity deposited on the surface is decomposed at a temperature of 600°C to 1200°C to drive tungsten and/or tantalum metal into the substrate surface.

In Japanese patent application No. 57-12829, reference is made to preventing the adhesion of tar by spray coating a blend containing aluminum chloride and cobalt oxide on a surface to provide a coated surface which has a catalytic activity for the decomposition of tar compounds into compounds that can be vaporized at low temperatures. According to Japanese patent application No. 56-30514, when tar collects on a surface which has been spray coated with a blend of a tar decomposing catalyst chosen from titanium oxide, zirconium oxide, vanadium oxide, chromium oxide, molybdenum oxide, tungsten oxide, manganese oxide, iron oxide, cobalt oxide, nickel oxide, copper oxide, platinum, palladium, rhodium, ruthenium, osmium or iridium and an inorganic binder of silicate, aluminum phosphate, glass, lithium, silicate solution, colloidal silica or alumina sol, it can be heated at 350°C for 60 minutes to remove the tar built up on the surface.

Thermal instability and fuel instability, referred to above, are becoming more significant with developing technology, and it will become even more significant as processes and machinery will be required to operate at higher temperatures as afforded by advances in materials technology and as the chemical quality of hydrocarbons for fuels, oils, lubricants, petrochemical processes (plastics and synthetics) and the like, decreases. Furthermore, hydrocarbon fluids, fuels and oils derived from non-petroleum sources, such as shale and coal, will have significantly more problems with thermal instability because of their high content of olefins, sulfur and other compounds. Accordingly, it is advantageous to provide coated articles and processes for preventing the formation of adverse degradation products and foulants in such applications where thermal instability, including fuel instability, is a problem as a result of exposure of such fluids to high temperatures.

In view of the foregoing, it can be seen that it would be desirable to provide coated metal articles, e.g., fuel containment articles for containing hot hydrocarbon fluid, in which or on which degradation products formed by thermal degradation of the hydrocarbon fluid is avoided, eliminated or reduced. It would also be desirable to provide a method of protecting metal surfaces which contact hot hydrocarbon fluid, from the deposit of degradation products of the hydrocarbon fluid. It can also be seen from the foregoing that it is desirable to provide methods and articles for use with hydrocarbon fuels wherein the hydrocarbon fuel can be used as a heat sink without the undesirable deposit of insoluble gums, coke, sulfur compounds or mixtures thereof on surfaces, e.g., containment surfaces. It is also desirable to provide methods and articles for containment of vaporized fuel to reduce NOₓ emission and to provide methods and articles for containment of low quality fuels derived from coal, shale and low grade crude oil.

The disadvantages of the prior art processes and techniques discussed above involve the need to alter the hydrocarbon chemistry, maintain strict control of impurities and/or provide additives and special processing such as pre-oxidizing treatment, passivation treatments and/or post-decomposition heat treatments using excessive amounts of heat, and the like. All of these techniques constrain the use of the fluid, increase cost and promote uncertainty as to the quality level of the fuel or treatment at a particular time. Furthermore, there are a multitude of processes, systems and devices including petrochemical processes, machine tools, automobile engines, aircraft gas turbine engines, and marine and industrial engines in which surface deposits from hydrocarbon fluids, fuels and oils are a major problem. Deposits can foul heat exchangers, plug fuel injectors and lubrication distribution jets, jam control valves and cause problems with many other types of operating and control devices associated with hydrocarbon fluids, fuels and oils. It is a primary objective of this invention to overcome these disadvantages.

### SUMMARY OF THE INVENTION

According to a first aspect of the invention, there is provided a method for preventing the deposit on a metal surface of thermal degradation products selected from metal sulfides, metal oxides or mixtures thereof derived from the reaction of sulfur, oxygen or mixtures thereof in hydrocarbon fluid with metal atoms which diffuse to the surface; comprising applying to the metal surface, without pre-oxidation thereof, a dense, non-porous and smooth diffusion barrier coating material of binary or ternary metal oxide, amorphous glass, metal fluoride or mixtures thereof; said diffusion barrier coating material being applied by chemical vapor deposition (CVD), without a carrier gas, and at a temperature of about 200°C to about 550°C, said diffusion barrier coating being thermally stable.

According to a second aspect of the invention, there is provided a method for preventing the deposit on a metal surface of coke derived from hydrocarbon fluid containing sulfur, oxygen or mixtures thereof in contact with the metal surface for a sufficient residence time to form coke, wherein the residence time sufficient to form coke is the result of the formation on the metal surface of metal sulfide from the reaction of sulfur and metal atoms which diffuse to the surface, the formation of metal oxide from the oxygen and metal atoms which diffuse to the surface, or mixtures thereof; comprising applying to the metal surface, without pre-oxidation thereof, a dense, non-porous and smooth diffusion barrier coating material of a thermally stable binary or ternary oxide or a thermally stable fluoride which prevents the formation of metal sulfide, metal oxide or mixtures thereof on the metal surface; said diffusion barrier coating material being applied by chemical vapor deposition (CVD), without a carrier gas, and at a temperature of about 200°C to about 550°C; said diffusion barrier coating being thermally stable.

The metal oxide, the metal fluoride or mixtures thereof may be applied by chemical vapor deposition, e.g., by effusive chemical vapor deposition of an organometallic compound on the surface without the use of carrier gas, without pre-oxidation of the surface and without thermal decomposition of the diffusion barrier material. The coating material itself, i.e., the diffusion barrier material, is inert to chemical reaction with hydrocarbons and hydrocarbon impurities, that is, it is inert to the chemical deformation of such thermal degradation products as gum, coke, sulfur compounds and the like in the fluid.

The coating material is deposited as a layer or layers on a surface which is adapted for contact with a hydrocarbon fluid, for example, a distillate fuel, and it inhibits or prevents the formation of gum, coke, sulfur compounds or mixtures thereof formed by the thermal decomposition of the hydrocarbon fluid. The coating material is also a physical diffusion barrier to the hot hydrocarbon fluid, that is, it will not permit the diffusion of or passing of the fluid through the material to the substrate on which the coating material is deposited. Thus, the metal oxide, amorphous glass or metal fluoride is a physical barrier located between the substrate and the hydrocarbon fluid.

From the foregoing, it is evident that the present invention solves the problems related to the formation of gum, coke, sulfur and other reactions which are chemically associated with contact between hot hydrocarbon fluid and the materials which the fluid contacts, for example, a wall. The present invention also solves the problems associated with the attachment or adherence of deposits to materials which the fluid contacts, by either physical means or chemical means or combinations thereof.

Although there is no intention to be bound by any particular theory or explanation of the mechanism(s) by which the present invention inhibits the formation of gum, coke and sulfur compounds which are formed by thermal degradation of hydrocarbon fluid, it is believed that chemical reactions take place between specific atoms and compounds which are part of the substrate chemistry and react under the influence of temperature with hydrocarbons and hydrocarbon impurities such as oxygen and sulfur and their compounds, to form metal-oxygen and metal-sulfur compounds. These metal compounds form deposits and/or precursors to deposits and provide an attachment mechanism between the substrate and other deposits. This theory is supported by the argument that chemical-absorption provides a much stronger surface bond than would simple physical absorption to the surface. In the specific case of gum deposits, it is theorized that metal atoms and metal compounds in the substrate can react to form hydrocarbon radicals which are then highly susceptible to further reaction such as with oxygen, to lead ultimately to polymerization and gums. Substrate reactions can also provide chemistry which is known in the art to be precursors to gums, and after the precursors attach to the substrate, they become the means for which gums and cokes and other deposits can grow by means of chemical or physical means, to consequential proportions.

The prior art, including U.S. Patent Nos. 4,297,150 and 4,343,658 discussed above, refer to the use of films, including metal oxide films, to inhibit coke formation. Although the purpose of these films is not easily deduced from the prior art, it might be assumed that the theories and reaction mechanisms referred to in the prior art apply in one form or another to the theories and mechanisms of the present invention, there are significant differences and advantages of the present invention over the prior art. As discussed above, like many chemical reactions, coke deposits are believed to be the result of molecular growth, i.e., formation of large molecules containing essentially carbon and hydrogen. In order for such molecular growth to occur, there must be sufficient residence time and availability of reactant species. When hot hydrocarbon fluid containing an impurity, e.g., sulfur, flows over a hot metal or metal alloy surface containing certain metals, e.g., iron, a strong affinity for the formation of iron sulfide causes iron atoms from the metal to diffuse to the surface and react with the sulfur. The iron sulfide formed by this mechanism (iron sulfide being essentially black in color and appearing to be coke) provides the essential means for coke formation. Because the iron sulfide crystals are irregular, the surface is easily wetted by the hydrocarbon fluids, e.g., the hydrocarbon at the surface has long chemical residence time. This, plus the availability of fresh reactants from flowing hydrocarbon contacting the surface causes the formation of coke.

Many coatings and coating materials, including the metal oxide films referred to in the prior art, are too porous to prevent either diffusion of metal atoms, e.g., iron, through the film or coating or to prevent diffusion of the hydrocarbon fluid through the film or coating to the metal substrate. Indeed, the porosity of the film or coatings of the prior art may contribute to the coking problem by trapping the hydrocarbon fluid at high temperature for a finite residence time, i.e., a residence time sufficient to permit formation of coke.

In accordance with the present invention, a metal oxide, amorphous glass or metal fluoride deposited by certain CVD processes, e.g., by effusive chemical vapor deposition, on the surface is sufficiently non-porous to shield objectionable metal atoms and metal compounds in the substrate or wall from reaction with impurities in the fuel. The same coating material is also sufficiently non-porous to physically prevent or inhibit diffusion of metal atoms and metal compounds into the hydrocarbon fluid. The same coating material is also sufficiently non-porous to prevent or inhibit diffusion of the hydrocarbon fluid and any impurities that it contains, to the substrate. By the CVD processes of the present invention, e.g., the effusive chemical vapor deposition of an organometallic compound on the surface without the use of carrier gas and without thermal decomposition of the coating deposited by the process, a non-porous diffusion barrier coating having a porosity sufficiently low to prevent or inhibit diffusion of metal atoms from the coated substrate therethrough, and having a porosity sufficiently low to prevent or inhibit diffusion of hydrocarbon fluid and any impurities it contains therethrough, is deposited on a metal surface adaptable to contact hydrocarbon fluids.

The diffusion barrier material of the present invention is generally a catalytically-inactive material. A catalytically-inactive material is one which is inert to the formation of any degradation products in hot hydrocarbon fluid which contacts it. Thus, when such a catalytically-inactive material is used as the liner (diffusion barrier material) on an article adapted to contact hydrocarbon fluid, there is substantially no thermal decomposition of the hydrocarbon fluid at elevated temperatures, for example, up to 900°F (482°C), and no sulfur compound or coke results or appears in the heated fluid.

### BRIEF DESCRIPTION OF THE DRAWINGS

The invention will now be described in greater detail, by way of example, with reference to the drawings in which:

Figure 1 is a partial longitudinal view of a high pressure turbine nozzle for a jet engine fueled by distillate fuel and incorporating the heat exchanger wall construction of the present invention.

Figure 2 is a sectional view taken along the line of II - II of Figure 1 showing fuel containment passages for circulating distillate fuel.

Figure 3 is a graph showing the relative weight gain of various metal coupons exposed to metal sulfide over a period of time.

Figures 4A, 4B and 4C are scanning electron beam micrographs (magnified 2000X) of a coupon of 321 stainless steel before testing (Figure 4A), after exposure to Jet-A fuel at 500°C for 2 hours (Figure 4B), and after exposure to Jet-A fuel at 500°C for 62 hours (Figure 4C).

Figures 5A and 5B are scanning electron beam micrographs (magnified 2000X) of an alumina coated 321 stainless steel coupon according to the present invention before testing (Figure 5A) and after exposure to Jet-A fuel at 500°C for 62 hours (Figure 5B).

Figures 6A and 6B are scanning electron beam micrographs (magnified 2000X) of a titania coated 321 stainless steel coupon according to the present invention (Figure 6A) and of a silica coated 321 stainless steel coupon according to the invention (Figure 6B), each after exposure to Jet-A fuel at 500°C for 62 hours.

Figures 7A and 7B are scanning electron beam micrographs (magnified 2000X) of a spinel coated 321 stainless steel coupon before testing (Figure 7A) and after exposure to Jet-A fuel at 500° for 162 hours (Figure 7B).

Figure 8 is photograph of two 304 stainless steel coupons showing before and after exposures to hot jet-A fuel.

Figures 9A, 9B, 9C and 9D are scanning electron beam photomicrographs (magnified 2000X) of a coupon of 304 stainless steel showing an uncoated (sand blasted) region before testing (Figure 9A), of an uncoated area after exposure to jet-A fuel at 521°C (970°F) for 8 hours (Figure 9B), of Ta₂O₅ coated 304 stainless steel coupon before testing (Figure 9C) and of Ta₂O₅ coated 304 stainless steel coupon after exposure to jet-A fuel at 521°C (970°F) for 8 hours (Figure 9D).

Figure 10 is scanning electron beam photomicrographs (magnified 10000X) of a Ta₂O₅ coated 304 stainless steel coupon before testing (Figure 10A) and of a Ta₂O₅ coated 304 stainless steel coupon after exposure to jet-A fuel at 521°C (970°F) for 8 hours (Figure 10B).

### DETAILED DESCRIPTION OF THE INVENTION

The terms hydrocarbon fluid, hydrocarbon fuel and distillate fuel may be used interchangeably herein.

The invention has applicability to any hydrocarbon fluid in which gum, coke and/or sulfur compounds form when the fluid is exposed to heat. Although the invention is not directed to or limited by any particular hydrocarbon fluid or hydrocarbon fuel, typical fuels for which the method and fluid containment articles of the present invention are adapted, and typical fuels from which the substrates of fluid containment articles are protected in accordance with the present invention, are the hydrocarbon or distillate fuels generally discussed above and include hydrocarbons and distillation products thereof which are generally liquid at room temperature. The fluids may be mixtures of hydrocarbons, mixtures of such distillation products, mixtures of hydrocarbons and distillation products, No. 1 or No. 2 diesel fuels, jet engine fuels, such as Jet-A fuel, or the foregoing fuels mixed with additives which are well-known in the art. Hydrocarbon fuels refer to the liquid fuels which are conventionally used in reaction motors, including but not limited to, industrial gas turbines, engines used in jet propelled aircraft or any other gas turbine engine, all of which are conventionally known in the art and, for example, certain of the aviation and other gas turbine fuels discussed in volume 3, third edition, ENCYCLOPEDIA OF CHEMICAL TECHNOLOGY, pages 328 - 351 (1979). Various hydrocarbon fuels which are particularly desirable for jet aircraft engines, are also described at column 6, lines 30 - 74 of U.S. Patent No. 2,782,592 and at column 2, lines 28 to column 3, line 23 of U.S. Patent No. 2,959,915.

Although all of the foregoing hydrocarbon fluids can be used in the present invention, and the advantages of the present invention apply thereto, it is an unexpected advantage of the present invention that conventional, untreated, low-cost hydrocarbon fluids can be used as fuel in jet engines without special handling, without further treatment, without costly quality control procedures, and without the need for special processing either prior to or subsequent to loading the fuel in the aircraft. Furthermore, these same advantages apply to all other processes and systems which utilize hydrocarbon fluids including but not limited to, the petrochemical and plastics industries, the synthetic fuels industry, commercial and home heating industries and the like.

The articles of the present invention may be any component which is adapted to contact or contain hot hydrocarbon fluid, for example, liquid hydrocarbon jet engine or diesel fuel, heated at a temperature at which degradation products form in hydrocarbons, hydrocarbons circulating in conduits, heat exchangers and the like, of refineries, polymer plants and power plants, furnaces and the like. Such articles for containing hot hydrocarbon fluid are defined herein as fluid containment articles. Examples of such fluid containment articles are discussed above and include any device in which hot hydrocarbon fluid can be confined, stored, transported or otherwise subjected to heat exchange without ignition or combustion of the hot fluid. The present invention is particularly adaptable to heat transfer surfaces where heat is transferred from a combustor or other heat source through a wall to liquid hydrocarbon fluid. Specific examples of articles for containing or contacting hot hydrocarbon fluids in accordance with the present invention include fuel storage tanks, conduits for transporting liquid fuel, coils and other devices for heat exchange contact with fuel, fuel injector surfaces, nozzles and the like.

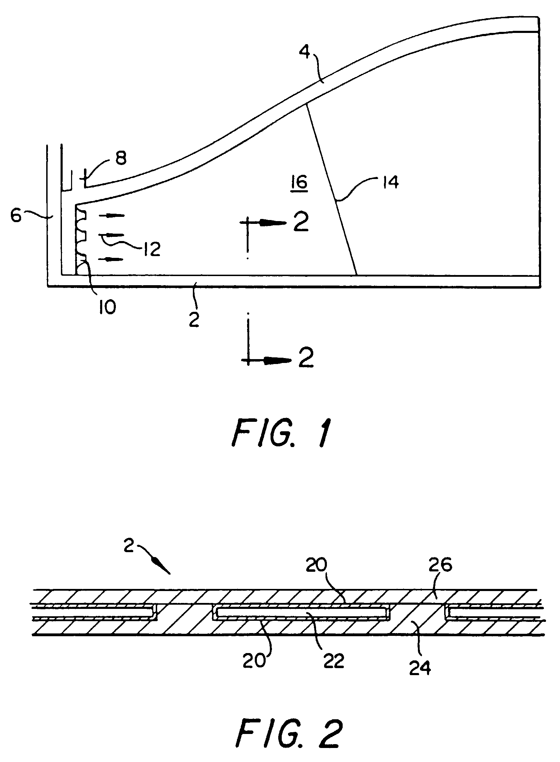

One such fluid containment article is shown in Figure 1 which represents a heat exchanger for cooling the high pressure turbine nozzle of a jet engine by transferring the heat generated therein to liquid hydrocarbon fuel confined in and transported through conduits or chambers adjacent the nozzle wall.

In Figure 1, liquid hydrocarbon fuel enters the high pressure turbine nozzle at conduit 6 and passes through heat exchanger 2 where heat from combustion chamber 16, for example, operating at a temperature such that the walls of the nozzle which form chamber 16 have a temperature of about 1200°F (about 649°C), is cooled by the liquid hydrocarbon fuel passing through fuel passageway 2. Thus, there is heat exchange between the walls of chamber 16 and the liquid hydrocarbon fuel passing through passageway 2. Hydrocarbon fuel also passes through passageway 4 where heat exchange also occurs between the wall of the chamber 16 and the hydrocarbon fuel in passageway 4. Heated and vaporized hydrocarbon fuel 12 flows into chamber 16 through gas injection ports 10.

Referring to Figure 2 which shows in more detail the fuel containment passageway of Figure 1, Figure 2 being taken along the lines II - II of Figure 1, hydrocarbon fuel passageway 2 contains walls 24 and 26 through which fuel passageway 22 is formed. Diffusion barrier material 20 of the present invention is coated by the CVD processes according to the present invention, e.g., by an effusive chemical vapor deposition process without the use of carrier gas, without pre-oxidation of the metal surface and at temperatures which will not thermally decompose the material, on substrates 24 and 26 so that it forms a coating over the metal surfaces of passageway 22. Thus, numeral 20 in Figure 2 represents the metal oxide, amorphous glass or metal fluoride material applied by the CVD processes according to the present invention, e.g., by the effusive CVD process without carrier gas, without pre-oxidation of the metal surfaces and without thermal decomposition of the coating material in accordance with the present invention.

Substrates 24 and 26 of Figure 2, which represent the heat exchanger walls of chamber 16 in the high pressure turbine nozzle of Figure 1, are generally constructed of any conventional material as well-known in the art. For example, such substrates may be stainless steel, corrosion-resistant alloys of nickel and chromium commercially available as INCONEL®, a trademark of the International Nickel Company, Inc., a high-strength, nickel-base, corrosion-resistant alloy identified as HASTELLOY®, a trademark of Union Carbide Corporation, and the like. It is these typical substrate materials which appear to cause or promote the formation of fuel thermal degradation products, such as gum, coke and/or sulfur compounds or mixtures thereof, in hydrocarbon fluids and fuels. It is the surface of substrates 26 and 24 which are adapted for contact with the hydrocarbon fuel by the formation of passageways, for example, as shown by numeral 22 in Figure 2, therein.

Hydrocarbon fuel can be transported through passageway 22 by any appropriate means (not shown), and the hydrocarbon fuel as it passes through passageway 22 contacts the substrate. However, in accordance with the present invention, passageway 22 is actually formed from diffusion barrier material 20, i.e., a binary or ternary metal oxide or mixtures thereof, an amorphous glass or mixtures thereof or a metal fluoride or mixtures thereof or a combination of any of the foregoing, which have been coated by the CVD processes according to the present invention, e.g., by the effusive CVD process without the use of carrier gas, without pre-oxidation of the metal surface and at temperatures which will not cause decomposition of the coated material, upon the metal surfaces of substrates 24 and 26 which form passageway 22. Accordingly, as the hydrocarbon passes through passageway 22, it actually contacts the effusive CVD deposited coating material 20. For best results, the layer or layers of coating material 20 are continuous and completely cover all surfaces of passageway 22 which are formed from substrates 24 and 26 and which provide a heat exchange relationship because of its contact with the hydrocarbon fuel.

In accordance with the present invention, the layer or layers of diffusion barrier material 20 which actually form passageway 22 by virtue of the continuous coating of deposited diffusion barrier material 20 on the surfaces of the passageway formed by substrates 24 and 26, are a diffusion barrier material which is catalytically-inactive and inhibits or prevents formation of coke, and is, for example, a binary or ternary metal oxide from titania, silica, alumina, tantala, or spinel, deposited by the CVD processes according to the present invention, e.g., the effusive CVD process.

In certain preferred embodiments, material 20 is also a physical diffusion barrier to the hydrocarbon fuel and prevents contact between the fuel and the metal substrate, or more specifically, between the fuel and certain metal atoms which normally migrate from the metal substrate when it is contacted with the fuel. Thus, material 20 which coats substrates 24 and 26 and thereby forms passageway 22, is an inert or catalytically-inactive material which prevents, reduces or inhibits the formation of coke and/or sulfur compounds, and thereby prevents, reduces or inhibits the deposit of coke and/or sulfur compounds on the surfaces of the passageway.

As explained above, hydrocarbon fluids containing sulfur or oxygen react with metal atoms in a metal surface to form metal sulfide or metal oxides. These sulfides or oxides bond chemically to the surface providing a microscopically coarse, textured surface. Hydrocarbon fluid then fills the vacancies or irregularities in this textured surface where it stagnates and provides sufficient residence time required to form coke. The coke reaction is usually exothermic causing additional self-heating. As the coke molecules grow, they lock themselves within the micro-cavities or irregularities of the sulfide or oxide coated surface layer. Once anchored to the surface, the coke continues to grow by its own coarse nature, trapping additional coke-forming reactants.

In order to prevent coke formation, the present invention provides a coating which prevents metal-sulfur and/or metal-oxygen reactions. This is achieved by coating the metal surface with a thin, atomically tight coating, i.e., non-porous to the diffusion of metal atoms, e.g., iron, chromium and the like, through the coating and non-porous to the diffusion of hydrocarbon fluid and impurities therein through the coating, e.g., in preferred embodiments by coating the metal surface with a thin, atomically tight binary or ternary metal oxide coating. In accordance with the present invention, it has been found that the metal oxide coating, the amorphous glass coating or the metal fluoride coating, defined herein as diffusion barrier material, must be formed on metal substrates by those CVD processes which form a coating on a metal surface wherein the coating is of a porosity sufficiently low to prevent or inhibit the diffusion of metal (metal atoms) from the metal-surface on which it is coated through the coating, i.e., atomically tight, and is of a porosity sufficiently low to prevent the diffusion of hydrocarbon fluid and impurities therein through the coating, i.e., non-porous. An example of such a CVD process is the effusive chemical vapor deposition of an organometallic compound without the use of a carrier gas, without pre-oxidation of the metal substrate and at temperatures which do not decompose the metal oxide applied on the metal substrate. The coating is essentially a diffusion barrier between metal atoms in the surface and sulfur and/or oxygen in the hydrocarbon fluid.

The quality of the coating with respect to diffusion must be such that metal atoms, such as, iron, nickel and chromium, cannot diffuse through the surface and contact sulfur or oxygen in the fuel. Furthermore, the coating itself must have a surface with no vacancies or irregularities which will provide areas of stagnation when flowing hydrocarbon fluids contact the surface, thereby increasing the residence time of the fluid to the extent that coke will form therein and continue to grow and accumulate therein. Consequently, the coating deposited by the effusive CVD process in accordance with the present invention must be smooth.

The oxides and fluorides which can be used as diffusion barrier coatings on the surface of metal substrates in accordance with the present invention are those which can be deposited by the CVD processes according to the present invention, e.g., by effusive chemical vapor deposition without use of carrier gas and without thermal decomposition of the diffusion barrier material to form uniformly thin, e.g., about 0.1 to 5.0 micrometers in thickness, coatings which inhibit or prevent metal diffusion therethrough at temperatures up to about 1000°F (about 538°C). The oxide and fluoride coatings which are useful in the present invention, must also be thermally stable, i.e., they must not decompose or melt at operating temperatures, e.g., about 500-1200°F (about 260°-649°C). The oxides or fluorides deposited in accordance with the present invention must be inert toward the metal substrate to which they are applied, i.e., they must be non-reactive with the metal in the metal substrate. The oxides or fluorides used as diffusion barrier coatings in accordance with the present invention must also be inert toward any hydrocarbon fluid which contacts the diffusion barrier coating, i.e., they must not react with, catalyze or otherwise convert the hydrocarbon fluids to decomposition products, defined herein as being non-reactive with the hydrocarbon. Alternatively stated, the oxides or fluorides used as diffusion barrier coatings must impede reactions in and with the hydrocarbon fluids, e.g., the coating material must not cause reactions which ultimately generate coke precursors.

The present invention is not limited to any particular organometallic compound for use in the CVD processes according to the present invention, e.g., the effusive CVD process. Any organometallic precursor compound which results in the deposit by the CVD processes according to the invention, e.g., by the effusive CVD process, of a binary or ternary metal oxide, amorphous glass or metal fluoride coating sufficient to form a diffusion barrier between metal atoms in the surface of the substrate and sulfur and/or oxygen in the hydrocarbon fluid and thereby prevents the formation of metal sulfide and/or metal oxide deposits from the fuel-metal substrate interaction so that there is insufficient residence time for the formation of coke in irregularities and vacancies formed in such metal sulfide and/or metal oxide deposits, may be used in accordance with the present invention.

In accordance with the present invention, the oxides and preferred fluorides are binary and ternary metal oxides and fluorides which prevent diffusion of metals in the metal wall into the hydrocarbon fluid where they cause reactions between impurities in the hydrocarbon fluid and metals from the wall. These select oxides and fluorides must be: (1) contiguous, dense and "atomically tight" enough to prevent significant metal diffusion at temperatures up to about 1000°F (about 538°C); (2) thermally stable up to high temperatures, e.g., about 500°-1200°F (about 260-649°C), thereby eliminating, for example, silver oxide (Ag₂O) as a diffusive CVD coated oxide for diffusion barrier coatings; (3) non-reactive with the metal wall, thereby eliminating, for example, lithium oxide, (Li₂O), sodium oxide (Na₂O), and calcium oxide (CaO) as diffusive CVD coated oxides for diffusion barrier coatings; and (4) not prone to catalyze, e.g., by oxidation/reduction, the hydrocarbon fluids to form or promote the formation of hydrocarbon cyclic aromatic and other undesirable coke precursors, thereby eliminating, for example, oxides of iron, cobalt, copper, lead, most transition metal oxides, and most metal oxides of the multivalent group VIII metals of the Periodic Chart of the elements as effusive CVD coated oxides for diffusion barrier coatings. By use of the term "dense" herein, is meant 98% and greater of the bulk density, i.e., non-porous.

The following binary metal oxides which can be deposited on metal surfaces by the effusive CVD process, are among the preferred metal oxide diffusion barrier coating materials of the present invention:
- Al₂O₃: Aluminum oxide (alumina)
- HfO₂: Hafnium oxide (hafnia)
- TiO₂: Titanium oxide (titania)
- Sc₂O₃: Scandium oxide (scandia)
- Y₂O₃: Yttrium oxide (yttria)
- ThO₂: Thorium oxide (thoria)
- SiO₂: Silicon oxide (silica)
- Ga₂O₃: Gallium oxide (gallia)
- In₂O₃: Indium oxide (india)
- GeO₂: Germanium oxide (germania)
- MgO: Magnesium oxide (magnesia)
- Ta₂O₅: Tantalum Oxide (tantala)
- ZrO₂: Zirconium oxide (zirconia)
- Ln₂O₃: where Ln = La, Ce, Pr, Nd, Pm, Sm, Eu, Gd, Tb, Dy, Ho, Er, Tm, Yb or Lu, i.e. any rare earth oxide.

Other oxides which may be used in accordance with the present invention, include any amorphous glass having the composition

XSiO₂ + YB₂O₃ + ZP₂O₅

where X + Y + Z = 1
where Y < O.5 and Z < 0.5.

Any ternary metal oxide containing the above listed binary metal oxides such as; for example,
- MgAl₂O₄: magnesium aluminum oxide (spinel)
- Y₂Si₂O₇: yttrium silicon oxide (yttrium silicate)
- Y₃Al₅O₁₂: yttrium aluminum garnet
- Ln₃Al₅O₁₂: rare earth aluminum garnet may also be used as diffusion barrier coatings in accordance with the present invention.

The diffusion barrier coatings of the present invention also include binary fluorides which meet the above-designated criteria, for example,
- BaF₂: barium fluoride
- LnF₃: where Ln = La, Ce, Pr, Nd, Pm, Sm, Eu, Gd, Tb, Dy, Ho, Er, Tm, Yb or Lu, i.e., any rare earth fluoride
- MgF₂: magnesium fluoride
and any metal oxy-fluorides of the composition:
- LnOF: where Ln = La, Ce, Pr, Nd, Pm, Sm, Eu, Gd, Tb, Dy, Ho, Er, Tm, Yb, or Lu, i.e., any rare earth oxy-fluoride.

Ternary fluorides which may be used in the method and articles of the present invention include BaMgF₄, EuMgF₄ or Ba₂MgF₆.

In accordance with the present invention, mixtures of these oxides, mixtures of these fluorides, mixtures of these oxide(s) and fluoride(s) and simple (neat) or composite oxides or fluorides can be deposited by the effusive CVD process on the metal substrates.

Although there is no intention to be limited to any particular organometallic compound which may be used as a precursor in the CVD processes according to the invention, e.g., the effusive CVD process, to deposit the respective binary or ternary metal oxides, amorphous glasses and metal fluorides, the following are examples of organometallic compounds which may be used in the present invention: disopropyl ethylacetoacetate aluminum as the precursor for alumina, hafnium dipivalonate as a precursor for hafnia, titanium ethoxide as the precursor for titania, scandium acetylacetonate as the precursor for scandia, yttrium dipivalonate as the precursor for yttria, thorium acetylacetonate as the precursor for thoria, silicon ethoxide as the precursor for silica, gallium acetylacetonate as the precursor for gallia, indium acetylacetonate as the precursor for india, germanium ethoxide as the precursor for germania, magnesium dipivalonate as the precursor for magnesia, magnesium aluminum isopropoxide as the precursor for spinel, yttrium dipivalonate and silicon acetate as the precursor for yttrium silicate, barium heptafluoro-octanedionate as the precursor for barium fluoride, magnesium heptafluoro-octanedionate as the precursor for magnesium fluoride, tantalum ethoxide dimer as the precursor for tantala, zirconium di-isopropoxide diacetylacetonate as the precursor for zirconia and a mixture of silicon ethoxide, boron triethoxide and triethyl phosphate as the precursor for amorphous glass. As an organometallic precursor compound for the Ln₂O₃ binary metal oxides, generally the dipivalonate of the particular element represented by Ln may be used in the effusive CVD process for the method of the present invention. For the LnF₃ binary fluorides, generally the heptafluoro- octanedionate of the particular element represented by Ln may be used in the effusive CVD process of the present invention. Mixtures of magnesium and barium heptafluoro-octane dionates are examples of organometallic precursor compounds which may be used in the effusive CVD process to make the ternary metal fluorides of the present invention.

Although the thickness of the diffusion barrier coating material, that is, the binary or ternary metal oxide, amorphous glass or metal fluoride coating is not critical, the metal oxide, amorphous glass or metal fluoride coating can be quite thin, preferably on the order of about 0.2 micron in order to prevent micro-cracking due to surface stresses which could degrade the diffusion barrier nature of the coating. In certain preferred embodiments, the metal oxide, amorphous glass or metal fluoride is about 0.1 micrometre to about 5.0 micrometres or greater, there being no critical upper limit.

The metal oxides, amorphous glass or metal fluorides which may be coated on the surface of a metal substrate to produce a diffusion barrier coating, and thereby prevent or inhibit fuel thermal reaction products, such as coke, metal sulfides, gums followed by polymers, and other products from the hydrocarbon, must be deposited by the CVD processes according to the present invention, e.g., by the effusive chemical vapor deposition process.

In accordance with the present invention, the effusive chemical vapor deposition must be carried out at a temperature at which the deposited metal oxide, e.g., amorphous metal oxide, does not decompose, i.e., convert to the metallic or some other form. In order to prevent such decomposition, the effusive CVD process is carried out at temperatures of about 200°C to about 550°C, and more preferably at about 400°C to about 450°C. In accordance with the present invention, heat may be applied as well known in the art by conventional means, e.g., an oven or vacuum furnace, and/or the article being coated may be heated by induction heating and the like. Although the pressure at which the effusive chemical vapor deposition is carried out is not critical, in preferred embodiments, the pressure is about 6.665 pascals (50 milliTorr) to about 66.65 pascals (500 milliTorr).

As used herein, effusive CVD, i.e., effusive chemical vapor deposition, or any CVD process which deposits a contiguous, dense, atomically tight, non-porous coating according to the present invention, is the vapor deposition of a binary or ternary metal oxide on a surface, the said metal oxide being derived from an organometallic compound, preferably a gaseous organometallic compound, at a temperature of about 200°C to about 550°C, and more preferably about 400°C to about 450°C, preferably at pressures less than atmospheric, e.g., at about 6.665 pascals (50 milliTorr) to about 66.65 pascals (500 milliTorr), without the use of a carrier gas.

In accordance with the present invention, when a CVD process according to the invention, e.g., the effusive CVD process, is used to deposit coatings on a surface, the surface must not be pre-oxidized. Pre-oxidation or any oxidation of a surface results in the formation of surface irregularities and/or roughness and reduces adhesion of the CVD coating material towards the substrate which is detrimental to the present invention. For example, as explained above, vacancies or irregularities, such as those caused by oxidation or pre-oxidation of the surface, increase residence time and promote the formation and accumulation of coke.

The coatings of the present invention are applied to the metal of the metal substrate, and accordingly, in preferred embodiments, the metal surface is a clean metal surface from which grease, grime, dirt and the like have been removed. Any conventional cleaning method or cleaning agent may be used to clean the metal surface as long as it does not roughen, deform or cause surface irregularities or vacancies which increase the residence time of flowing fluid in contact therewith. In certain preferred embodiments, the cleaning agent is a conventional organic solvent, e.g., liquid hydrocarbons. One class of liquid hydrocarbons typically used to clean surfaces is the mono- and dialkyl-ethers of ethylene glycol and their derivatives marketed under the trademark, CELLOSOLVE®. Any cleaning method or agent used in accordance with the present invention must not cause oxidation of (or the formation of oxides on) the metal surface. Such oxides cause surface irregularities and vacancies and interfere with the effectiveness of the coatings, e.g., the metal oxide coatings applied by the effusive CVD process in accordance with the present invention.

Furthermore, the CVD processes according to the invention, e.g., the effusive CVD process, must be carried out at temperatures which do not decompose the coating material. As used herein, any temperature which converts or transforms or otherwise causes a reaction in or of the deposited diffusion barrier material to another form, or otherwise causes a reaction in or a reaction of the deposited material, is a temperature which decomposes the deposited material. For example, when the deposited material is a metal oxide and the temperature is reached at which metal in the metal oxide is converted to the metallic form, it is defined herein as thermal decomposition of the metal oxide. Accordingly, the CVD processes according to the present invention, e.g., the effusive CVD process, are carried out at temperatures of about 200°C to about 550°C to avoid thermal decomposition of the deposited diffusion barrier material. At these temperature, the integrity and effectiveness of the coating material are maintained and decomposition of the coatings is avoided.

The length of time required to carry out the CVD processes according to the invention, e.g., the effusive CVD process, is not critical, the length of time of exposure of the metal substrate to the organometallic compound being dependent on the thickness of the coating desired on the surface of the substrate. It is only necessary to treat the surface of the metal substrate by the effusive or other CVD process according to the invention until the desired thickness of the layer or layers of coating material is achieved, and one skilled in the art can determine the length of time required to achieve the desired thickness of coating material without undue experimentation by subjecting the surface of the metal substrate to the organometallic compound at a designated temperature and pressure until the desired thickness of the coating is achieved, e.g., until the thickness of the deposited metal oxide is about 0.4 micrometre.

In certain preferred embodiments, the metal oxide is amorphous so as to be homogeneous and closely packed (dense or atomically tight) in order to prevent diffusion and contact between the fluid and metal atoms in the metal substrate, especially in the case of the diffusion barrier material. Non-amorphous or crystalline metal oxides can also be deposited on substrates in accordance with the present invention as long as such deposits or coatings form a continuous, closely packed (dense or atomically tight) coating which is sufficient to prevent diffusion and contact between the fluid and metal atoms in the metal substrate.

Although the present invention has utility in any fuel containment article or in any fuel containment system in which fuel does not undergo combustion, and it is particularly useful in forming a diffusion barrier coating in fuel containment articles and fuel containment systems wherein the fuel is used as a heat exchange medium to remove heat from various systems in gas turbines, both industrial and those used in aircraft and the like, it is particularly useful in the heat exchanger surfaces in fuel systems of a gas turbine, a scramjet engine, a ramjet engine, or a turbojet engine or as a conduit for transporting heated hydrocarbon fuel in a fuel system of any of the foregoing. Unlike the prior art processes and fluid containment articles and systems, the processes and fluid containment articles of the present invention can use conventional low-cost fluids without any disadvantage. The prior art processes and fluid containment articles must use fuels containing additives, special fuel processing procedures and/or special handling, all of which are costly, create additional problems and generate or promote the generation of NOₓ. With the processes and articles of the present invention, there is a substantially improved system in which NOₓ generation can be minimized.

Application of the benefits to be derived from the present invention are quite extensive. One application of these benefits is to provide a heat exchanger surface which can be used to gasify jet fuel without fouling of the heat exchanger surface. The gaseous fuel can then be injected into a gas turbine combustor in a uniform fashion rapidly mixing with air so as to burn at a uniform temperature. Such uniform temperature combustion would substantially reduce the formation of nitrogen oxide pollutants. Another application would also involve heating the jet fuel to a very high temperature during use as a capacious heat sink for cooling various engine and aircraft parts and systems, such as the air used for cooling the engine turbine blades, discs and vanes. Another application would involve coating parts such as fuel nozzles, injectors, and flow distribution jets so as to avoid deposit buildup which would plug the nozzles, injectors and jets. Another application would involve coating of valves so as to avoid sticking and seizing from gums or cokes. These and other applications and benefits of the present invention will become obvious to those skilled in the art based on the teachings of the present invention.

The following specific examples describe the methods and articles of this invention. They are intended for illustrative purposes only and should not be construed as limiting the present invention.

### EXAMPLES

Specific tests have been conducted on metals which are typically used for walls and materials for parts which contact hot hydrocarbons and normally form coke deposits thereon. The diffusion barrier materials were deposited on the metals by effusive chemical vapor deposition (CVD) in thicknesses of about 0.2 - 1.5 micrometers. Alumina (Al₂O₃), silica (SiO₂), titania (TiO₂) and spinel (MgAl₂O₄) were deposited on the metals and are representative of the oxides and fluorides which are diffusion barrier coating materials, of the present invention.

### Example 1:

Type 321 stainless steel coupons containing iron, chromium and nickel were used as the materials representing typical metal walls. Test coupons were in the as-rolled condition with about 32 RMS surface finish. These coupons are representative of the typical metal chemistry and surface texture of steel tubing used, e.g., to convey hydrocarbon fluids, such as kerosene fuel. The test coupons were coated with the particular oxide by the effusive CVD technique described below.

A stainless steel planchette or coupon measuring 50mm long by 8mm wide by 2mm thick made from 321 stainless steel was coated with a 0.4 micrometre thick layer of silica (SiO₂) by an effusive chemical vapor deposition process. The planchette was cleaned with a non-oxidizing cleaning agent to remove grease, and placed in a heated vacuum furnace maintained at a pressure between about 6.665 pascals (50 milliTorr) to about 66.65 pascals (500 milliTorr). Heat was applied at a temperature of about 400°C-450°C to an organometallic precursor, silicon acetate, for SiO₂, in the furnace. The silicon acetate organometallic precursor flowed over the substrate and deposited SiO₂ onto the substrate surface. No carrier gas was used. This resulted in about a 0.4 micron thickness of atomically tight amorphous SiO₂ coating deposited on the planchette.

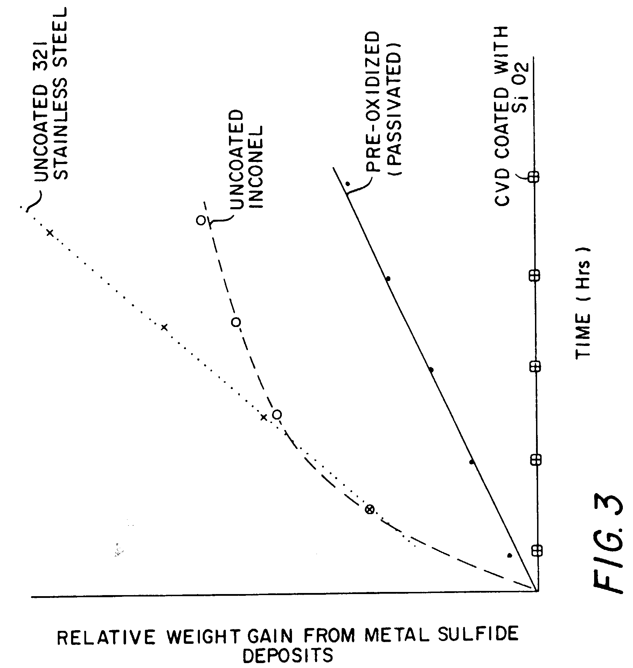

Coated and uncoated test coupons were exposed to concentrated levels of sulfur in the form of flowing thioacetamide (CH₃CSNH₂)/N₂ gas (1%/99%) at 450°C (842°F) at 101300 pascals (one atmosphere) pressure for 1 to 3 hours. Relative weight gain from metal sulfide deposits vs. time is shown in Figure 3. Figure 3 is a comparative statement of relative amount of sulfide deposit versus comparable exposure time (in hours) for each of the samples shown in the graph. Note that the effusive CVD coated SiO₂ coupon developed no sulfide deposits, thus indicating the effectiveness of the SiO₂ diffusion barrier deposited by the effusive CVD process in preventing sulfide deposits. Pre-oxidized (passivated in oxygen gas) coupons showed a slight (but inconsequential) improvement over the uncoated 321 stainless steel metal. An uncoated coupon of INCONEL® 718 nickel/chromium stainless is also shown for comparison to uncoated 321 stainless steel and coatings applied by the CVD process of the present invention.

### Example 2:

Effusive CVD SiO₂ coated, uncoated and pre-sulfurized 321 stainless steel coupons were exposed to flowing chemically-pure decane, octane and dodecane gas, which is representative of the pure (hydrocarbon) chemistry of aircraft Jet-A kerosene fuel. The effusive CVD SiO₂ coated coupons were coated as described in Example 1. After 5 to 10 hours of exposure at the same conditions as the thioacetamide tests in Example 1, there were no deposits formed on the effusive CVD SiO₂ coated coupons. Uncoated coupons showed very small amounts of coke deposit. Coupons which had preexisting deposits of metal sulfides from the thioacetamide test showed very large coke deposits. Thus, the effusive CVD SiO₂ coatings inhibited coke deposits, and the metal sulfide deposits promoted coke deposits. Microprobe analysis of the deposits showed that chromium diffused to the metal surface to form a sulfide deposit. Iron diffused from the metal surface, through the sulfide deposit to the surface of the coke deposit, and nickel diffused through all deposits leaving the surface as a sulfide.

### Example 3:

Several coated and uncoated 321 stainless steel coupons were placed together in a gold plated fixture and subjected to simulated flowing conditions of ordinary Jet-A kerosene fuel. Ordinary Jet-A fuel may contain as much as 0.4% by weight, of free sulfur and sulfur compounds. The test was run at 2.75 x 10⁶ pascals (400 psi (27.2 atmospheres)) and 500°C (932°F) for 62 hours. The test coupons were examined after 2, 18 and 62 hours. Jet-A liquid flow rate was 80 ml/min (1.27 gal. per hour) with supercritical gaseous flow Reynolds number in excess of 10,000 over the coupons.

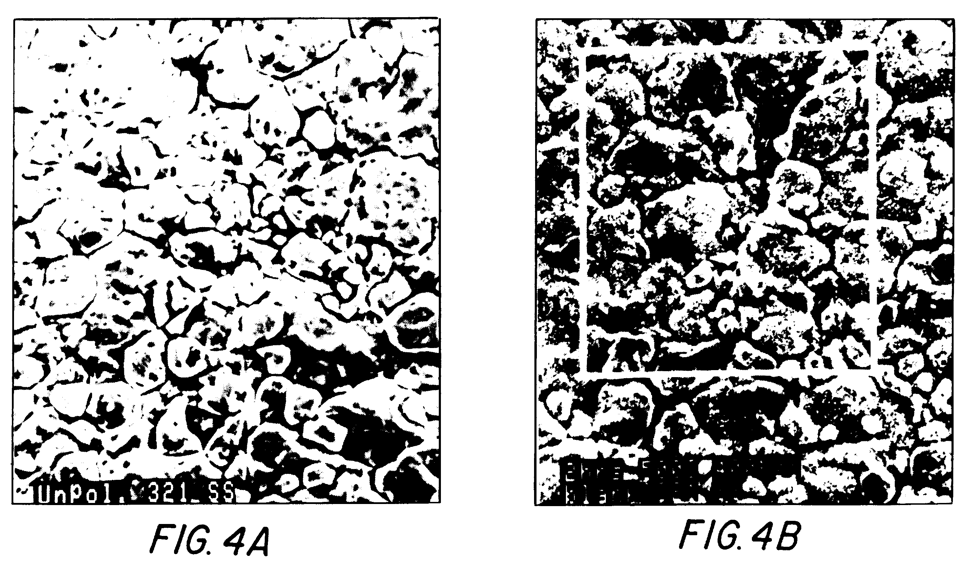

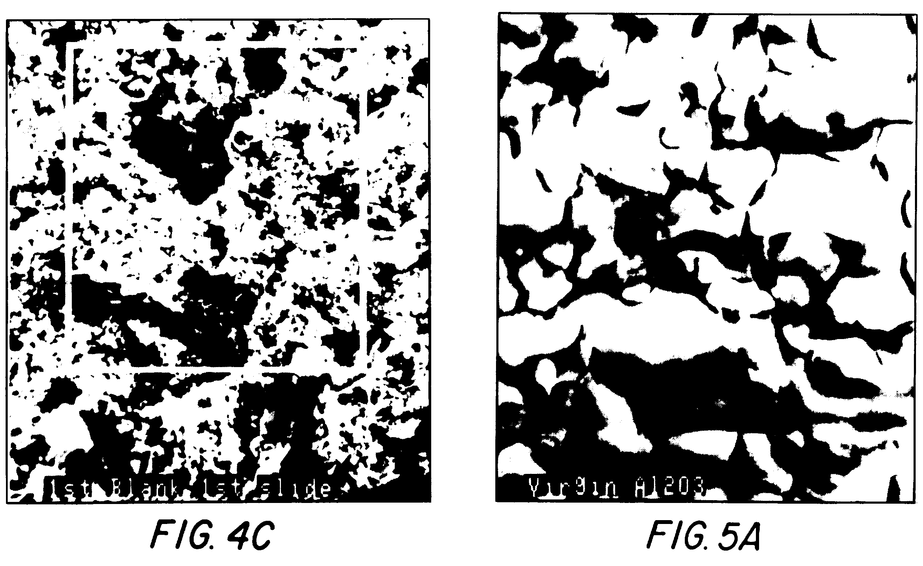

The results of the tests on the uncoated 321 stainless steel coupon are shown in Figure 4A which shows an uncoated coupon at 2000X power before the test; Figure 4B shows the uncoated coupon at 2000X after 2 hours of exposure; and Figure 4C shows the uncoated coupon after 62 hours of exposure. Figure 4C shows the deposit structure adhering to the surface. An additional coke deposit in excess of 0.0127 cm (0.005 inch) thickness has been removed from the surface. These results indicate an average deposit growth rate of about 0.00635 cm (0.0001 inch) per hour. Microprobe analysis of the deposits showed the crystals in Figure 4B to be chromium and sulfur (chromium sulfide). The deposits in Figure 4C are chromium/sulfur (chromium sulfide) iron/sulfur (iron sulfide) and carbon. The 0.00127 cm (0.0005 inch) deposit removed from the surface was predominately carbon (coke).

### Example 4:

A stainless steel planchette or coupon having the dimensions shown above in Example 1 was cleaned with a non-oxidizing cleaning agent and placed in a heated vacuum furnace. The pressure was maintained at between about 50 milliTorr to about 66.65 pascals (500 milliTorr). The oven was heated at about 400°C to about 450°C and an organometallic precursor for Al₂O₃, diisopropoxy aluminum ethylacetoacetate, was passed into the furnace and flowed over the heated substrate therein. Al₂O₃ deposited on the substrate surface at a thickness of about 1.2 micrometres. No carrier gas was used.

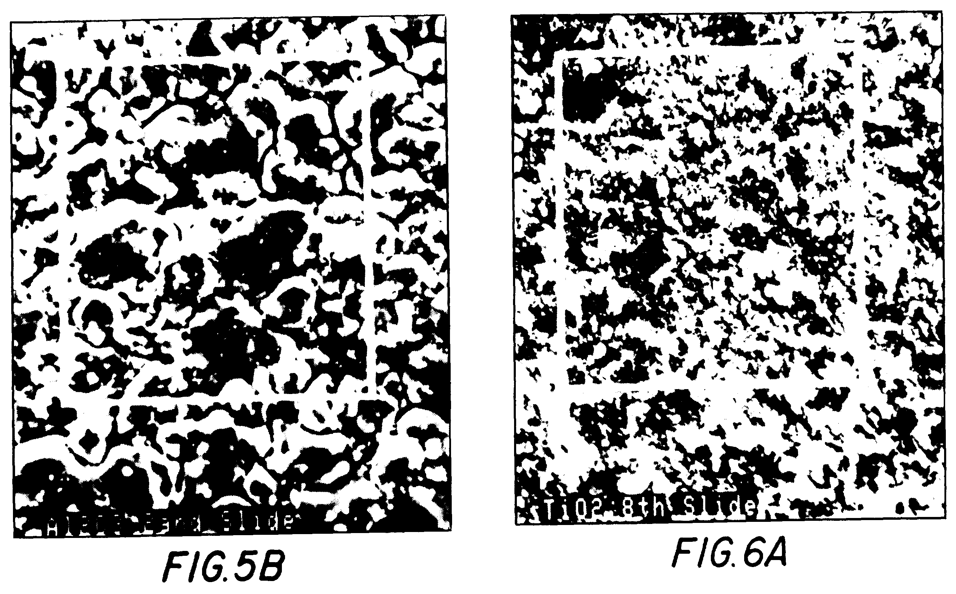

The results of tests conducted on a coupon coated with 1.2 microns of Al₂O₃ are shown in Figure 5A which is before the test (virgin Al₂O₃) and Figure 5B which is after 62 hours of exposure to Jet-A fuel at a temperature of 500°C. The few micron-size particles resting loosely on the surface are nickel sulfide which has migrated from deposits upstream of the Al₂O₃. As can be seen, no deposits have formed on the Al₂O₃ coated coupon. The photomicrograph (Figure 5B) of the coupon exposed to Jet-A fuel at 500°C for 62 hours shows that Al₂O₃ provides a good diffusion barrier but that it is somewhat lacking in surface continuity.

### Example 5:

Stainless steel coupons having the dimensions and cleaned as shown above in Example 1 were placed in a heated vacuum furnace. A coupon was coated with 1.5 microns (thickness) of SiO₂ as in Example 1. Another coupon was coated with 0.3 micrometre of TiO₂ by the effusive CVD method of Example 1 using titanium ethoxide as the organometallic precursor.

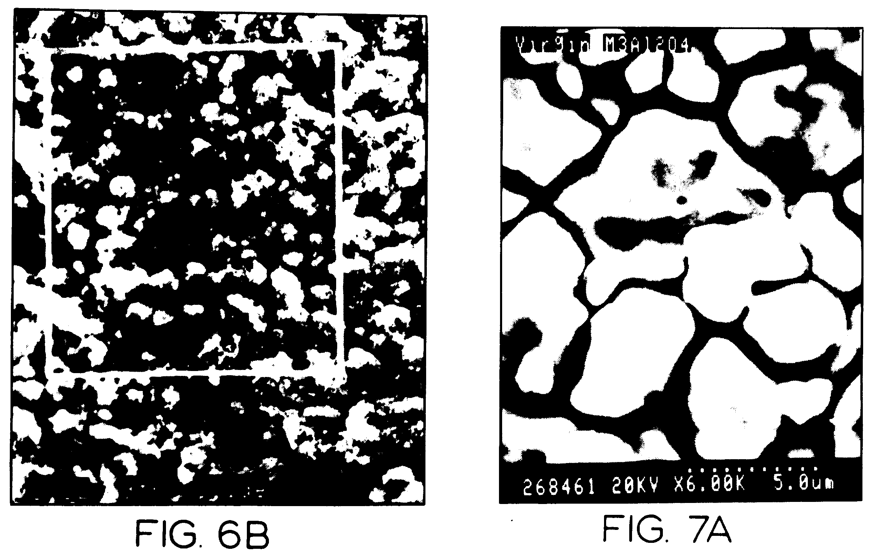

The results of tests conducted on titania and silica are shown in Figure 6A which shows a photomicrograph at 2000X of a 321 stainless steel coupon coated with 0.3 micrometre of TiO₂ and Figure 6B which shows a photomicrograph at 2000X of a 321 stainless steel coupon coated with 1.5 microns of SiO₂. These photomicrographs of coupons exposed to Jet-A fuel heated at 500°C for 62 hours show that SiO₂ is reasonably good and relatively easy to apply and that with TiO₂, there is evidence of a small amount of diffusion barrier breakdown.

The gold plating used on the test figure was not effective in preventing coke deposits and was later replaced with a SiO₂ coating.

### Example 6:

A stainless steel planchette of 321 s.s. having the dimensions and cleaned as in Example 1 was placed in a heated vacuum furnace. The planchette was coated with spinel having a thickness of 0.5 micrometre by the effusive CVD method of Example 1 using aluminum magnesium isopropoxide as the organometallic precursor.

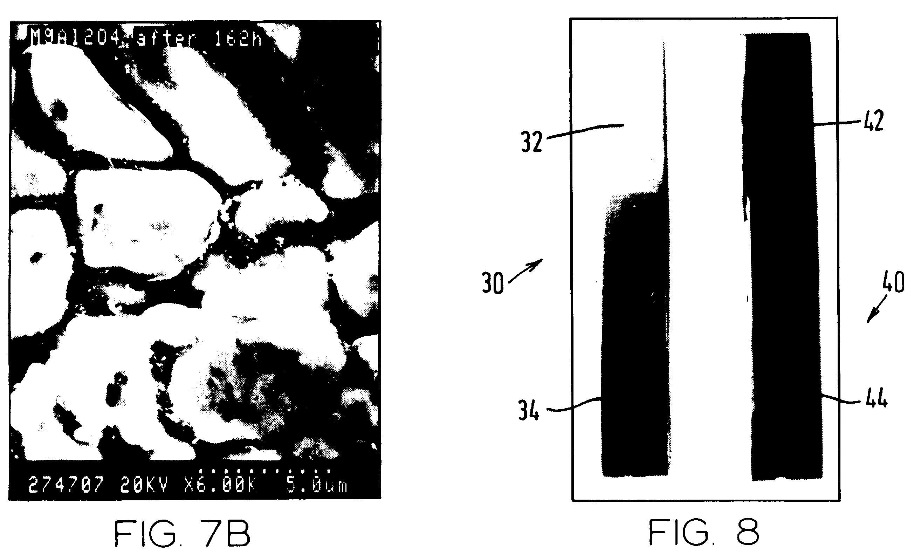

The results of tests conducted on the spinel coating are shown in Figure 7A which shows a photomicrograph at 2000X of the coupon coated with spinel before the test (virgin spinel) and Figure 7B which shows a photomicrograph at 2000X of the coupon coated with spinel after 162 hours of exposure to Jet-A fuel at 500°C. As can be seen, no deposits have formed on the spinel-coated planchette.

### Example 7:

A stainless steel planchette or coupon measuring 50mm long by 8mm wide by 2mm thick made from 304 stainless steel was coated with a 0.4 micrometre thick layer of tantalum oxide, Ta₂O₅, by an effusive chemical vapor deposition process. The planchette was cleaned with a non-oxidizing cleaning agent to remove grease, and placed in a heated vacuum furnace maintained at a pressure between about 50 milliTorr to about 66.65 pascals (500 milliTorr). Heat was applied at a temperature of about 400°C-450°C to an organometallic precursor, tantalum ethoxide dimer (Ta₂(OC₂H₅)₁₀) in the furnace. The tantalum ethoxide dimer flowed over the substrate and deposited Ta₂O₅ onto the substrate surface. No carrier gas was used. This resulted in about a 0.4 micrometre thickness of atomically tight, dense amorphous Ta₂O₅ coating deposited on the planchette.

A test was conducted by flowing commercial grade Jet-A kerosene aviation fuel over the planchette for 8 hours at 521°C (970°F) and 2.9 x 10⁶ pascals (420 p.s.i.a). A total of 0.336 kg (0.74 pounds) of hot (970°F) fuel was passed over the planchette during the 8-hour test. No attempt was made to remove air from the fuel.

In Figure 8, planchette 30 was photographed prior to exposure to coking conditions, that is, prior to the test set forth above. On planchette 30, lower portions or section 34 was coated and remained coated with the tantalum oxide, and upper portion or section 32 was sand blasted to remove the coating of tantalum oxide. Planchette 30 was exposed to the test conditions specified above, and after exposure to the flowing, hot Jet-A fuel, the planchette was removed and photographed and is shown as planchette 40 in Figure 8.

Comparison of planchettes 30 and 40 shows that a deposit formed on uncoated (upper) portion 42 of planchette 40. After examination of coated region 44 and uncoated region 42 of planchette 40, the deposit on region 42 was removed by burning in oxygen to form carbon dioxide and sulfur dioxide. The total amount of deposit was determined to be 0.2 mg which corresponds to a deposit rate of 3.1 micrograms/hr/cm² for the 8-hour test. Based on prior tests of uncoated samples, it is judged that the deposit rate is highest during initial exposure (up to 100 micrograms/hr/cm² for a 0.5 hour duration test), and that the weight ratio of carbon to sulfur composition of the deposit is about 2 to 1.

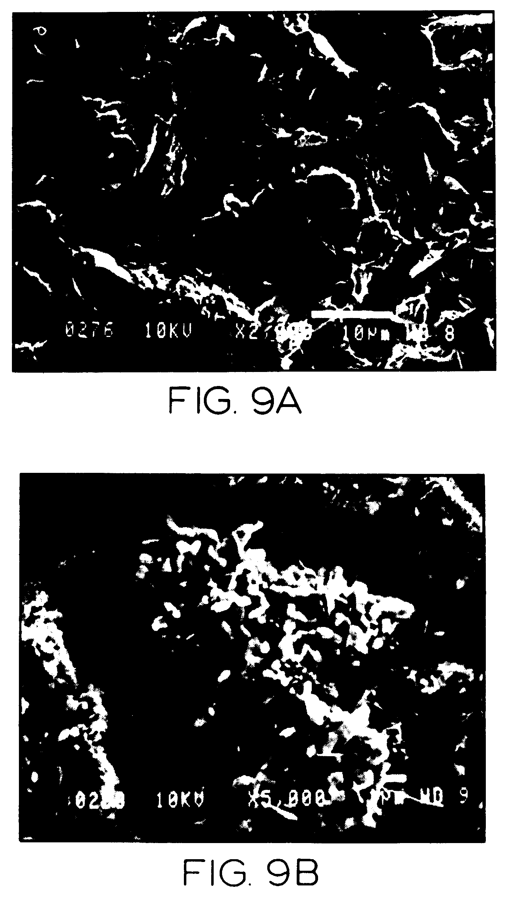

Figure 9A shows uncoated (sand blasted) region 32 of planchette 30 before the test. Figure 9B shows the deposit formed on uncoated region 42 of planchette 40 after the test. The rock-shaped crystalline deposit shown in Figure 9B was found to contain up to 30 - 40% sulfur. As the sulfur concentration in the Jet-A fuel is only about 200 ppm, this represents a high concentration in the deposit. These same crystals were determined by x-ray diffraction to be chromium sulfide, indicating that the sulfur impurities in the fuel reacted with chromium in the 304 stainless steel. No chromium could be found in the Jet-A fuel feed, hence the chromium had to come from the steel. The black appearance of the deposit is characteristic of either carbon or chromium sulfide, leading to the speculation that chromium sulfide could easily be misinterpreted as coke.

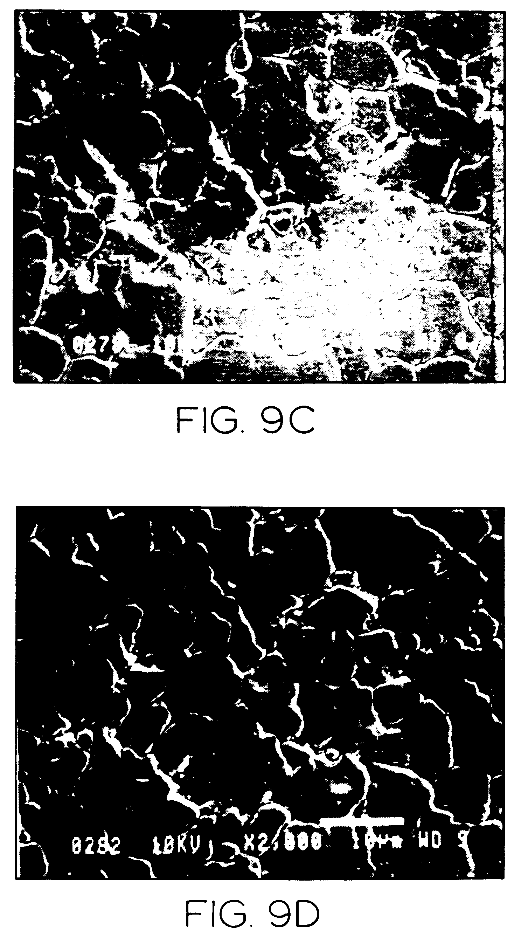

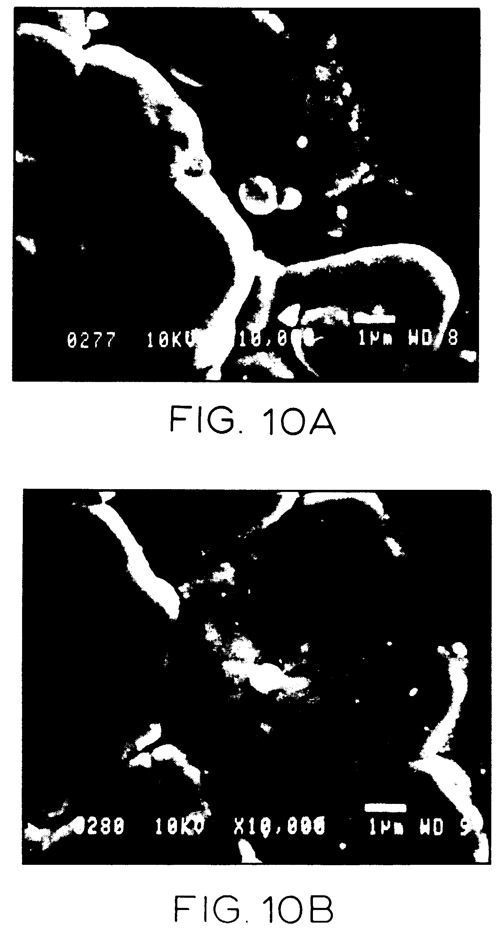

Figure 9C shows coated portion 34 of planchette 30 before the test. Figure 9D shows coated portion 44 (different area) of the planchette after the test. In Figures 10A and 10B, magnified portions of coated portion 44, even at 10,000X magnification, demonstrate that there is no evidence of deposit on the Ta₂O₅ coated 304 stainless steel, Figure 10A representing the 0.4 micron thick coated sample before the test and Figure 10B representing the sample after the JET-A fuel test at 510°C (950°F) and 3 x 10⁶ pascals (435 p.s.i.a.), 0.08 pph for 7 hours. Clearly the Ta₂O₅ prevented contact between chromium in the metal and sulfur in the fuel. No other type of deposit was observed on the coating.

The foregoing clearly establishes that oxides applied by effusive CVD act as diffusion barrier materials and prevent or retard diffusion between the metal substrates and hydrocarbons and thereby prevent or retard surface deposit formations.

Based on the foregoing results, it is further evident that other diffusion barrier materials can be formed from other metal oxides deposited on substrate metals and alloys using the effusive CVD process.

While other modifications of the invention and variations thereof which may be employed within the scope of the invention, have not been described, the invention is intended to include such modifications as may be embraced within the following claims.

## Claims

1. A method for preventing the deposit on a metal surface of thermal degradation products selected from metal sulfides, metal oxides or mixtures thereof derived from the reaction of sulfur, oxygen or mixtures thereof in hydrocarbon fluid with metal atoms which diffuse to the surface; comprising applying to the metal surface, without pre-oxidation thereof, a dense, non-porous and smooth diffusion barrier coating material of metal oxide, amorphous glass, metal fluoride or mixtures thereof; said diffusion barrier coating material being applied by chemical vapor deposition (CVD), without a carrier gas, and at a temperature of about 200°C to about 550°C, said diffusion barrier coating being thermally stable.

2. A method for preventing the deposit on a metal surface of coke derived from hydrocarbon fluid containing sulfur, oxygen or mixtures thereof in contact with the metal surface for a sufficient residence time to form coke, wherein the residence time sufficient to form coke is the result of the formation on the metal surface of metal sulfide from the reaction of sulfur and metal atoms which diffuse to the surface, the formation of metal oxide from the oxygen and metal atoms which diffuse to the surface, or mixtures thereof; comprising applying to the metal surface, without pre-oxidation thereof, a dense, non-porous and smooth diffusion barrier coating material of a thermally stable binary or ternary oxide or a thermally stable fluoride which prevents the formation of metal sulfide, metal oxide or mixtures thereof on the metal surface; said diffusion barrier coating material being applied by chemical vapor deposition (CVD), without a carrier gas, and at a temperature of about 200°C to about 550°C; said diffusion barrier coating being thermally stable.

3. The method according to claim 1 or claim 2, wherein the metal oxide, amorphous glass metal fluoride or mixtures thereof are applied by effusive chemical vapor deposition of an organometallic compound on the surface without the use of carrier gas and without thermal decomposition of the diffusion barrier coating.

4. The method according to any preceding claim, wherein the metal fluoride is a binary metal fluoride or a ternary metal fluoride.

5. The method according to any preceding claim, wherein the binary metal oxide is tantala, alumina, hafnia, titania scandia, yttria, thoria, silica, gallia, india, germania, zirconia, magnesia or Ln₂O₃ wherein Ln is the element, La, Ce, Pr, Nd, Pm, Sm, Eu, Gd, Tb, Dy, Ho, Er, Tm, Yb or Lu.

6. The method according to any preceding claim, wherein the ternary metal oxide is magnesium aluminum oxide or yttrium silicon oxide.

7. The method according to claim 4, wherein the binary metal fluoride is barium fluoride, magnesium fluoride, LnF₃ or LnOF where Ln is the element, La, Ce, Pr, Nd, Pm, Sm, Eu, Gd, Tb, Dy, Ho, Er, Tm, Yb or Lu.

8. The method according to claim 4, wherein the ternary metal fluoride is BaMgF₄, Ba₂MgF₆ or EuMgF₂.

9. The method according to any one of claims 1 to 3, wherein the oxide is an amorphous glass of the formula:
XSiO₂ + YB₂O₃ + ZP₂O₅
wherein X + Y + Z = 1, and
wherein Y and Z are each less than 0.5.

10. The method according to any preceding claim, wherein the oxide or fluoride applied to the metal surface is applied at a thickness of about 0.1 to about 5.0 micrometres.

## Patentansprüche

1. Verfahren zum Verhindern der Abscheidung von thermischen Abbauprodukten, ausgewählt aus Metallsulfiden, Metalloxiden oder deren Mischungen, erhalten aus der Reaktion von Schwefel, Sauerstoff oder deren Mischungen in Kohlenwasserstoff-Flüssigkeit mit Metallatomen, die zur Oberfläche diffundieren, auf einer Metalloberfläche, umfassend das Aufbringen eines dichten, nicht-porösen und glatten Diffusionssperren-Überzugsmaterials aus binärem oder ternärem Metalloxid, amorphem Glas, Metallfluorid oder deren Mischungen auf der Metalloberfläche ohne deren vorherige Oxidation, wobei das Diffusionssperren-Überzugsmaterial durch chemisches Dampfabscheiden (CVD) ohne ein Trägergas und bei einer Temperatur von etwa 200°C bis etwa 550°C aufgebracht wird und das Diffusionssperren-Überzugsmaterial thermisch stabil ist.

2. Verfahren zum Verhindern des Abscheidens von Koks aus Kohlenwasserstoff-Flüssigkeit, enthaltend Schwefel, Sauerstoff oder deren Mischungen, in Kontakt mit einer Metalloberfläche für eine genügende Aufenthaltszeit zur Bildung von Koks auf der Metalloberfläche, wobei die Aufenthaltszeit, die zur Bildung von Koks genügt, das Ergebnis der Bildung von Metallsulfid durch Umsetzung von Schwefel und Metallatomen, die zur Oberfläche diffundieren, der Bildung von Metalloxid aus Sauerstoff und Metallatomen, die zur Oberfläche diffundieren, oder deren Mischungen auf der Metalloberfläche ist, umfassend das Aufbringen eines dichten, nicht-porösen und glatten Diffusionssperren-Überzugsmaterials aus einem thermisch stabilen binären oder ternären Oxid oder einem thermisch stabilen Fluorid auf der Metalloberfläche ohne deren vorherige Oxidation, das die Bildung von Metallsulfid, Metalloxid oder deren Mischungen verhindert, wobei das Diffusionssper-ren-Überzugsmaterial durch chemische Dampfabscheidung (CVD) ohne ein Trägergas und bei einer Temperatur von etwa 200°C bis etwa 550°C aufgebracht wird, und der Diffusionssperren-Überzug thermisch stabil ist.

3. Verfahren nach Anspruch 1 oder 2, worin das Metalloxid, amorphe Glas, Metallfluorid oder deren Mischungen durch ausströmende, chemische Dampfabscheidung einer metallorganischen Verbindung auf die Oberfläche ohne Einsatz von Trägergas und ohne thermische Zersetzung des Diffusionssperren-Überzuges aufgebracht werden.

4. Verfahren nach einem vorhergehenden Anspruch, bei dem das Metallfluorid ein binäres Metallfluorid oder ein ternäres Metallfluorid ist.

5. Verfahren nach einem vorhergehenden Anspruch, worin das binäre Metalloxid, Tantaloxid, Aluminiumoxid, Hafniumoxid, Titanoxid, Scandiumoxid, Yttriumoxid, Thoriumoxid, Siliciumoxid, Galliumoxid, Indiumoxid, Germaniumoxid, Zirkoniumoxid, Magnsiumoxid oder Ln₂O₃ ist, worin Ln das Element La, Ce, Pr, Nd, Pm, Sm, Eu, Gd, Tb, Dy, Ho, Er, Tm, Yb oder Lu ist.

6. Verfahren nach einem vorhergehenden Anspruch, worin das ternäre Metalloxid Magnesiumaluminiumoxid oder Yttriumsiliciumoxid ist.

7. Verfahren nach Anspruch 4, worin das binäre Metallfluorid, Bariumfluorid, Magnesiumfluorid LnF₃ oder LnOF ist, worin Ln das Element La, Ce, Pr, Nd, Pm, Sm, Eu, Gd, Tb, Dy, Ho, Er, Tm, Yb oder Lu ist.

8. Verfahren nach Anspruch 4, worin das ternäre Metallfluorid BaMgF₄, Ba₂MgF₆ oder EuMgF₂ ist.

9. Verfahren nach einem der Ansprüche 1 bis 3, worin das Oxid ein amorphes Glas der Formel ist:
XSiO₂ + YB₂O₃ + ZP₂O₅,
worin X + Y + Z = 1 und Y und Z jeweils weniger als 0,5 sind.

10. Verfahren nach einem vorhergehenden Anspruch, worin das Oxid oder Fluorid in einer Dicke von etwa 0,1 bis etwa 5,0 µm auf die Metalloberfläche aufgebracht wird.

## Revendications

1. Procédé pour empêcher le dépôt sur une surface métallique de produits de dégradation thermique, choisis parmi les sulfures métalliques, les oxydes métalliques et leurs mélanges, issus de la réaction du soufre, de l'oxygène ou de leurs mélanges, présents dans des hydrocarbures fluides, avec des atomes de métal qui diffusent vers la surface, procédé qui comprend l'application à la surface métallique, sans oxydation préalable de cette dernière, d'un matériau de revêtement dense, non-poreux et lisse, faisant obstacle à la diffusion et constitué d'un oxyde métallique binaire ou ternaire, d'un verre amorphe, d'un fluorure métallique ou d'un mélange de ces produits, ledit matériau de revêtement faisant obstacle à la diffusion étant appliqué par dépôt chimique à partir d'une phase gazeuse (CVD), sans gaz porteur et à une température d'environ 200°C à environ 550°C, et ledit revêtement faisant obstacle à la diffusion étant thermiquement stable.

2. Procédé pour empêcher le dépôt sur une surface métallique de coke provenant d'un hydrocarbure fluide contenant du soufre, de l'oxygène ou un mélange des deux, en contact avec la surface métallique pendant un temps de contact suffisant pour la formation de coke, le temps de contact suffisant pour la formation de coke découlant de la formation sur la surface métallique de sulfure métallique provenant de la réaction du soufre et des atomes de métal qui diffusent vers la surface, de la formation d'oxyde métallique à partir de l'oxygène et des atomes de métal qui diffusent vers la surface, ou d'un mélange des deux, procédé qui comprend l'application à la surface métallique, sans oxydation préalable de cette dernière, d'un matériau de revêtement dense, non-poreux et lisse, faisant obstacle à la diffusion et constitué d'un oxyde binaire ou ternaire, thermiquement stable, ou d'un fluorure thermiquement stable qui empêche la formation de sulfure métallique, d'oxyde métallique ou d'un mélange des deux sur la surface métallique, ledit matériau de revêtement faisant obstacle à la diffusion étant appliqué par dépôt chimique à partir d'une phase gazeuse (CVD), sans gaz porteur et à une température d'environ 200°C à environ 550°C, et ledit revêtement faisant obstacle à la diffusion étant thermiquement stable.

3. Procédé selon la revendication 1 ou 2, dans lequel l'oxyde métallique, le verre amorphe, le fluorure métallique ou leurs mélanges. est appliqué sur la surface par dépôt chimique effusif à partir d'une phase gazeuse constituée d'un composé organométallique, sans utilisation d'un gaz porteur et sans décomposition thermique du revêtement faisant obstacle à la diffusion.

4. Procédé selon l'une quelconque des revendications précédentes, dans lequel le fluorure métallique est un fluorure métallique binaire ou un fluorure métallique ternaire.

5. Procédé selon l'une quelconque des revendications précédentes, dans lequel l'oxyde métallique binaire est l'oxyde de tantale, l'alumine, l'oxyde de hafnium, l'oxyde de titane, l'oxyde de scandium, l'oxyde d'yttrium, l'oxyde de thorium, la silice, l'oxyde de gallium, l'oxyde d'indium, l'oxyde de germanium, la zircone, la magnésie ou Ln₂O₃ dans lequel Ln représente l'élément La, Ce, Pr, Nd, Pm, Sm, Eu, Gd, Tb, Dy, Ho, Er, Tm, Yb ou Lu.

6. Procédé selon l'une quelconque des revendications précédentes, dans lequel l'oxyde métallique ternaire est l'oxyde d'aluminium et de magnésium ou l'oxyde de silicium et d'yttrium.

7. Procédé selon la revendication 4, dans lequel le fluorure métallique binaire est le fluorure de baryum, le fluorure de magnésium, LnF₃ ou LnOF, Ln représentant l'élément La, Ce, Pr, Nd, Pm, Sm, Eu, Gd, Tb, Dy, Ho, Er, Tm, Yb ou Lu.

8. Procédé selon la revendication 4, dans lequel le fluorure métallique ternaire est BaMgF₄, Ba₂MgF₆ ou EuMgF₄.

9. Procédé selon l'une quelconque des revendications 1 à 3, dans lequel l'oxyde est un verre amorphe de formule :
XSiO₂ + YB₂O₃ + ZP₂O₅
dans laquelle X + Y + Z = 1, et
dans laquelle Y et Z représentent chacun un nombre inférieur à 0,5.

10. Procédé selon l'une quelconque des revendications précédentes, dans lequel l'oxyde ou fluorure appliqué à la surface métallique est appliqué en une épaisseur d'environ 0,1 à environ 5,0 micromètres.
